# EUROPEAN PATENT SPECIFICATION

(11) **EP 0 719 874 B1**
(45) Date of publication and mention of the grant of the patent: **11.11.1998**
(21) Application number: 95850234.6
(22) Date of filing: 22.12.1995
(51) Int. Cl.: C23C 14/08, C23C 14/58, C23C 14/14, C23C 14/06

(54) **Process of and apparatus for forming thin films of metallic compounds**
Verfahren und Vorrichtung zur Herstellung dünner Schichten von metallischen Verbindungen
Procédé et appareillage pour la formation de couches minces en composés métalliques

(30) Priority: 26.12.1994 JP 337931/94
(43) Date of publication of application: 03.07.1996
(73) Proprietor: SHINCRON CO., LTD., Shinagawa-ku, Tokyo (JP)
(72) Inventor: Tamoto, Junichi, Tokyo (JP); Okada, Katsuhisa, Tokyo (JP); Narisawa, Seishi, Tokyo (JP); Ito, Takashi, Tokyo (JP)
(74) Representative: Modin, Jan

(56) References cited:
- EP-A- 0 244 253
- EP-A- 0 428 358
- DE-A- 4 331 885
- US-A- 4 842 704
- PATENT ABSTRACTS OF JAPAN, unexamined applications, C field, vol. 13, no. 69, February 16, 1989 THE PATENT OFFICE JAPANESE GOVERNMENT page 84 C 569; & JP-A-63 259 070 (SHARP CORP.)

## Description

This invention relates to a process of and apparatus for forming thin films of metallic compounds by means of a sputtering technique.

Sputtering processes are widely known for the production of thin films of metals and metallic compounds such as metal oxides in which the targets of these materials are sputtered until their films are formed by deposition to a desired order of thickness. The rate of deposition of metallic compounds is generally inferior by comparison to metals per se. The same is true even with a metal target if oxygen is used in a reactive sputtering atmosphere, resulting in the formation of a metallic oxide film, with a further drawback in that the rate of deposition decreases as the amount of oxygen increases.

Metallic compound films as produced by sputtering or vacuum deposition are often depleted of their constituent elements as in the case for example of a SiO₂ target which ends up with a film composition SiOx(x<2). The depletion of oxygen in such a case may be countered by the addition of a mixture of argon (Ar) and oxygen (O₂) gases, but at the sacrifice of a reduction in the rate of film deposition by about one half to one-third.

The present inventors have previously proposed (as disclosed in Japanese Laid-Open Patent Publication No. 62-284076) a process in which an ultra-thin film is sputtered from a titanium or like metal onto a substrate and the resultant film is subjected to irradiation of an ion beam of oxygen or like reactive gas so as to transform into that of a titanium oxide or like metallic compound, these process steps being repeatedly carried out to achieve a desired film thickness. It has been later found, however, that the use of an ion bombarding gun involves a number of equipment components such as filaments, screen electrode, suppressor electrode and the like, not to speak of the necessity of replacing worn filaments, accompanied by pollution of a vacuum chamber, increased power requirement, undue temperature rise due to the use of neutralizers and other associated problems.

Japanese Laid-Open Patent Publication No. 4-4967 discloses a similar process and apparatus in which a sputtering electrode is combined with an ion gun. This prior system has a drawback in that the ion source is susceptible to the influence of arcing at the side of the sputter source as both sources are electrically coupled, and further in that a plurality of high vacuum pumps are required, leading to upsized and complicated equipment layout.

Furthermore, EP 428 358 discloses a method and an apparatus where a layer of sputtered metal is converted into an oxide in a reactive plasma, the two steps being alternated repeatedly by way of a rotating substrate holder. However, there is no effective isolation between the film-forming and plasma exposure zones.

With the foregoing drawbacks of the prior art in view, the present invention seeks to provide an improved process of and apparatus for forming ultra-thin films of metallic compounds at high rate of yields and with stable quality.

More specifically, the invention provides a process of forming films of metallic compounds which comprises a first step of sputtering a metal or a metallic compound target to form an ultra-thin film over a substrate in a film-forming zone and a second step of transforming said ultra-thin film of metal into that of a metallic compound by exposure to plasma of a reactive gas in a plasma exposure zone, wherein the film-forming zone is shielded against entry of reactive gas from the plasma exposure zone, the plasma exposure zone is shielded against entry of sputtering gas from the film-forming zone, and said first and second steps are alternated repeatedly until the resultant film is finished to a desired thickness.

The process of the invention is carried into practice by an apparatus for forming films of metallic compounds which comprises a vacuum tank, a substrate holder rotatably mounted therein, a sputtering electrode means carrying a metal or metallic compound target thereon and defining a film-forming zone for forming a sputtered ultra-thin film over a substrate and an induction coupled plasma generator generating a reactive gas plasma and defining a plasma exposure zone to which said sputtered ultra-thin film is exposed, there being provided a shield, which surrounds laterally the target and extends from the target into close proximity to the rotating substrate holder for preventing the reactive gas from entering into the film-forming zone, and another shield, which surrounds laterally the generated reactive gas plasma and extends into close proximity to the rotatable substrate holder for preventing sputtering gas from entering said gas exposure zone.

Figure 1 is a partially cross-sectional plan view schematically illustrating an apparatus employed to carry the process of the invention into practice.

Figure 2 is a cross-sectional view taken along the lines I, II and III of Figure 1.

The term "ultra-thin film" as used herein denotes a significantly thin individual film or lamina (for example of the order of 1-6 angstroms) formed during each cycle of the inventive process in contract to or as distinct from a final product film resulting from superimposition of such individual films.

The term "reactive gas" as used herein includes an oxidative gas such as oxygen, ozone and N₂O, a nitrative gas such as nitrogen and a carbonative gas such as acetylene.

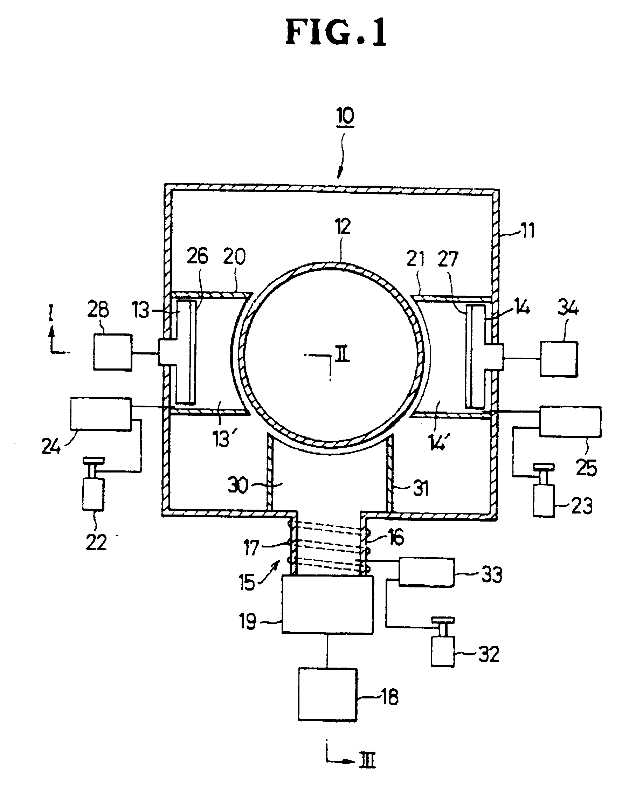

Referring now to the drawings, there is shown a film-forming apparatus 10 embodying the invention. The apparatus 10 comprises a vacuum tank 11, a substantially cylindrical substrate holder 12 rotatably mounted in the vacuum tank 11, a pair of sputtering electrodes 13,14 disposed in confronting relation to each other diammetrically across the holder 12 and an inductive coupling type plasma generator or plasma source 15 including RF (high frequency) discharge chamber 16 in the form of a quartz tube having RF coils 17 wound thereon which are energized from a high frequency power source 18 through a matching box 19. Each of the sputtering electrodes 13,14 defines at its inner surface a film-forming zone 13',(14') which is surrounded by a shielding member 20,(21) and which creates therein controlled sputtering atmosphere upon supply of a sputtering gas such as argon from a sputtering gas supply bottle 22,(23) through a massflow meter 24,(25). There are shown in Figure 1 two sputtering electrodes 13,14 for purposes of illustration and in consideration of the case where two different target materials are used.

Target materials eligible for the purpose of the invention exemplarily include aluminum, titanium, zirconium, niobium, tin, chromium, tantalum, iron, silicon, tellurium, nickel-chrome and indium-tin alloys, of which silicon, titanium and zirconium are particularly preferred.

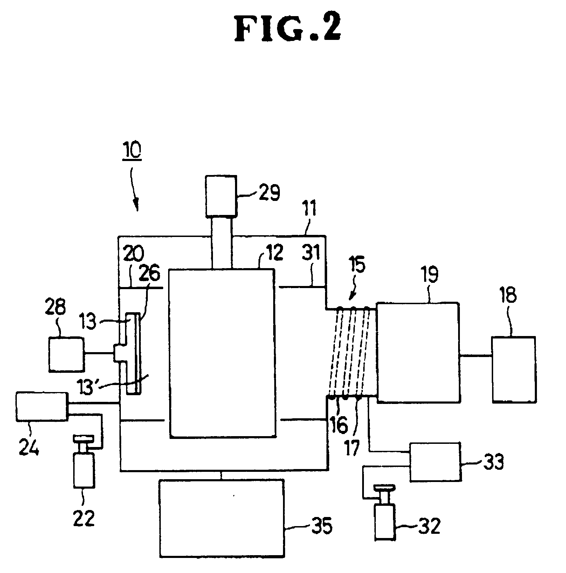

For purposes of illustration, silicon (Si) is used as a target 26 attached on one sputtering electrode 13 and titanium (Ti) as a target 27 on the other sputtering electrode 14. Argon gas is introduced from the sputtering gas bottle 22, and the sputtering electrode 13 is energized with power from a power source 28 whereupon the silicon target 26 is sputtered to form an ultra-thin film of silicon upon a substrate (not shown) supported on the holder 12 rotating with power from a drive motor 29 (Figure 2). The Si film thus formed is then exposed to a plasma of oxygen gas introduced from a reactive gas supply bottle 32 through a massflow meter 33 and generated at a plasma exposure zone 30 defined in communication with the RF discharge chamber 16 and surrounded by a shielding member 31.

The reactive gas atmosphere at the plasma exposure zone 30 may be also controlled by establishing a magnetic field in close proximity to the plasma source 15 thereby to vary and regulate the plasma density.

Upon exposure to the oxygen gas plasma, the Si sputtered ultra-thin film on the substrate is oxidized and transformed into a film of SiO₂. With the substrate holder 12 held in rotation, the cycle of alternate sputtering and plasma exposure modes of operation is repeated as many times as is required to achieve a desired cumulative thickness of the final product film. The process of the invention is also directed to the sputtering of a silicon oxide (SiO₂) film, in which instance the flow of oxygen gas from the supply bottle 32 can be regulated via massflow meter 33 to replenish its level in the RF discharge chamber 16 to make up for the loss or depletion of oxygen (SiOx<2) incurred during sputtering thereby ensuring stable SiO₂ film formation.

The other sputtering electrode 14 carrying a zirconium (Zr) target 27 is energized with power from a power source 34 to effect the formation of a Zr sputtered ultra-thin film on the substrate, followed by exposure of the film to a reactive gas plasma. The cycle of this operation is repeated in a manner similar to the SiO₂ film formation already described. The target material on the electrode 14 may be other metals or oxides thereof such as titanium or titanium oxide.

The above sputtering and plasma exposure operation on selected target materials is repeatedly carried out until there is produced a film laminate of SiO₂, TiO₂ or ZrO₂ on the substrate which is anti reflection.

The film-forming apparatus 10 according to the invention is advantageous in that the film-forming zone 13',(14') at the sputtering electrode, 13,(14) shielded as at 20,(21) against intrusion of the reactive or oxygen gas from the oxygen supply bottle 32 which would otherwise adversely affect the rate of sputtering, and the plasma exposure zone 30 at the RF discharge chamber 16 is likewise shielded as at 31 against entry of the sputtering gas from the sputtering gas supply bottle 22,(23), the respective gases being separately withdrawn via vacuum pump 35 (Figure 2). The arrangement is effective particularly where a plurality of sputtering targets are provided in close vicinity. The inventive apparatus 10 is further advantageous in that the sputtering discharge and the reactive gas inductive coupling discharge are independently controllable without mutual interference to ensure stability of discharge and freedom from accidents and also in that the RF coils 17 at the plasma source 15 are disposed externally of the system so as to prevent possible pollution of the vacuum tank 11. The apparatus 10 contrary to the Kaufmann ion gun system, can dispense with the necessity of filaments, screen electrodes, suppressor electrodes, neutralizers and other equipment components and hence can be built relatively simple and compact.

The above film-forming operation according to the invention was conducted under the following conditions:
(1) Target: Silicon (Si)
   Feed Power: 3.6 kw
   Substrate Temperature: room temperature
   Substrate Holder Drive: 100 r.p.m.
   Shielded Zone Pressure: 0.27 Pa (2.0 x 10⁻³ Torr)
   Ultra-thin Film Thickness: 2 - 6 angstroms
(2) Target: Zirconium (Zr)
   Feed Power: 1.9 kw
   Substrate Temperature: room temperature
   Substrate Holder Drive: 100 r.p.m.
   Shielded Zone Pressure: 0.66 Pa (5.0 x 10⁻³ Torr)
   Ultra-thin Film Thickness: 1 - 4 angstroms
(3) Reactive Gas Plasma: Oxygen (O₂)
   Feed Power: 1 kw
   Pressure: 0.19 Pa (1.4 x 10⁻³ Torr)

Having thus described the invention, it will be obvious to those skilled in the art that changes or modifications may be made in the specific form and construction of the above film-forming apparatus without departing from the scope of the appended claims.

## Claims

1. A process of forming films of metallic compounds which comprises a first step of sputtering a metal or a metallic compound target to form an ultra-thin film over a substrate in a film-forming zone (13', 14') and a second step of transforming said ultra-thin film of metal into that of a metallic compound by exposure to plasma of a reactive gas in a plasma exposure zone (30) **characterized in** that said film-forming zone is shielded against entry of reactive gas from said plasma exposure zone, said plasma exposure zone is shielded against entry of sputtering gas from said film-forming zone, and said first and second steps are alternated repeatedly until the resultant film is finished to a desired thickness.

2. A process according to claim 1, **characterized in** that said target is selected from materials of the group consisting of aluminum, titanium, zirconium, niobium, tin, chromium, tantalum, iron, silicon, tellurium, nickel-chrome and indium-tin.

3. A process according to claim 1 or 2, **characterized in** that said reactive gas is selected from the group consisting of oxygen, ozone, N₂O, nitrogen and acetylene.

4. A process according to any one of claims 1-3, **characterized in** that said plasma is generated by an induction coupled plasma generator (15).

5. An apparatus for forming films of metallic compounds which comprises a vacuum tank (11), a substrate holder (12) rotatably mounted therein, a sputtering electrode means (13, 14) carrying a metal or metallic compound target (26, 27) thereon and defining a film-forming zone (13', 14') for forming a sputtered ultra-thin film over a substrate and an induction coupled plasma generator (15) generating a reactive gas plasma and defining a plasma exposure zone (30) to which said sputtered ultra-thin film is exposed, **characterized in** that there is provided a shield (20, 21), which surrounds laterally said target into close proximity to said rotatable substrate holder (12) for preventing the reactive gas from entering said film-forming zone (13', 14'), and another shield (31), which surrounds laterally the generated reactive gas plasma and extends into close proximity to said rotatable substrate holder (12) for preventing sputtering gas from entering said plasma exposure zone (30).

6. An apparatus according to claim 5, arranged to effect alternate sputtered film formation and exposure of the sputtered film to a reactive gas plasma in a repeated cycle of operation.

7. An apparatus according to claim 5 or 6, **characterized in** that a pair of said sputtering electrode means (13, 14) are disposed in confronting relation to each other diametrically across said rotatable substrate holder (12).

## Patentansprüche

1. Verfahren zur Ausbildung dünner Schichten aus metallischen Verbindungen, bei welchem in einem ersten Schritt ein Target aus Metall oder einer metallischen Verbindung zum Ausbilden eines ultra-dünnen Films über einem Substrat in einer Film-Ausbildungszone (13', 14') gesputtert wird, und in einem zweiten Schritt der ultra-dünne Film aus Metall in denjenigen aus einer metallischen Verbindung durch Aussetzen an ein Plasma aus einem reaktiven Gas in einer Plasmaaussetzungszone (30) umgewandelt wird, dadurch gekennzeichnet, daß die Film-Ausbildungszone gegen den Eintritt von reaktivem Gas aus der Plasmaaussetzungszone abgeschirmt ist, die Plasmaaussetzungszone gegen den Eintritt von Sputtergas aus der Film-Ausbildungszone abgeschirmt ist, und der erste und der zweite Schritt wiederholt abgewechselt werden, bis der resultierende Film bis auf eine gewünschte Dicke fertiggestellt ist.

2. Verfahren nach Anspruch 1, dadurch gekennzeichnet, daß das Target aus Materialien der Gruppe ausgewählt wird, die aus Aluminium, Titan, Zirconium, Niob, Zinn, Chrom, Tantal, Eisen, Silizium, Tellurium, Nickel-Chrom und Indium-Zinn besteht.

3. Verfahren nach Anspruch 1 oder 2, dadurch gekennzeichnet, daß das reaktive Gas aus der Gruppe ausgewählt wird, die aus Sauerstoff, Ozon, N₂O, Stickstoff und Acetylen besteht.

4. Verfahren nach einem der Ansprüche 1 bis 3, dadurch gekennzeichnet, daß das Plasma mittels eines induktionsgekoppelten Plasmagenerators (15) erzeugt wird.

5. Vorrichtung zum Ausbilden von Filmen aus metallischen Verbindungen, welche einen Vakuumbehälter (11), einen darin drehbar angeordneten Substrathalter (12), ein Sputterelektrodenmittel (13, 14), das ein Target (26, 27) aus Metall oder einer metallischen Verbindung darauf trägt und eine Film-Ausbildungszone (13', 14') zum Ausbilden eines gesputterten ultra-dünnen Films über einem Substrat definiert, und einen induktionsgekoppelten Plasmagenerator (15) aufweist, der ein Plasma aus reaktivem Gas erzeugt und eine Plasmaaussetzungszone (30) definiert, welcher der gesputterte ultra-dünne Film ausgesetzt wird, dadurch gekennzeichnet, daß eine Abschirmung (20, 21) vorgesehen ist, welche das Target in unmittelbarer Nähe zu dem drehbaren Substrathalter (12) lateral umgibt, um das reaktive Gas am Eintreten in die Film-Ausbildungszone (13', 14') zu hindern, und eine weitere Abschirmung (31) vorgesehen ist, die das erzeugte Plasma aus reaktivem Gas lateral umgibt und sich in unmittelbare Nähe zu dem rotierbaren Substrathalter (12) erstreckt, um das Sputtergas am Eintreten in die Plasmaaussetzungszone (30) zu hindern.

6. Vorrichtung nach Anspruch 5, die zum abwechselnden Bewirken einer Sputterfilmausbildung und Aussetzung des Sputterfilms an ein Plasma aus reaktivem Gas in einem wiederholten Betriebszyklus ausgelegt ist.

7. Vorrichtung nach Anspruch 5 oder 6, dadurch gekennzeichnet, daß ein Paar der Sputterelektrodenmittel (13, 14) zueinander in gegenüberstehender Beziehung diametral über den rotierbaren Substrathalter (12) angeordnet ist.

## Revendications

1. Procédé de formation de couches de composés métalliques qui comprend une première étape de pulvérisation cathodique d'une cible de métal ou d'un composé métallique pour former une couche ultramince sur un substrat dans une zone de formation de couche mince (13', 14') et une seconde étape de transformation de ladite couche ultramince de métal en celle d'un composé métallique par exposition à un plasma d'un gaz réactif dans une zone d'exposition au plasma (30), caractérisé en ce que ladite zone de formation de couche est protégée contre l'entrée de gaz réactif en provenance de ladite zone d'exposition au plasma, ladite zone d'exposition au plasma est protégée contre l'entrée de gaz de pulvérisation cathodique en provenance de ladite zone de formation de couche, et lesdites première et seconde étapes sont répétées en alternance jusqu'à ce que la couche résultante soit finie à une épaisseur souhaitée.

2. Procédé selon la revendication 1, caractérisé en ce que ladite cible est sélectionnée à partir de matières du groupe constitué par l'aluminium, le titane, le zirconium, le niobium, l'étain, le chrome, le tantale, le fer, le silicium, le tellure, le nickel-chrome et l'étain dopé à l'indium.

3. Procédé selon la revendication 1 ou 2, caractérisé en ce que ledit gaz réactif est sélectionné à partir du groupe constitué par l'oxygène, l'ozone, le N₂O, l'azote et l'acétylène.

4. Procédé selon l'une quelconque des revendications 1 à 3, caractérisé en ce que ledit plasma est produit par un générateur de plasma couplé par induction (15).

5. Appareillage de formation de couches de composés métalliques qui comprend un réservoir à vide (11), un support de substrat (12) monté de manière rotative en son sein, des moyens formant électrode de pulvérisation cathodique (13, 14) portant une cible de métal ou de composé métallique (26, 27) sur ces derniers et définissant une zone de formation de couche (13', 14') pour former une couche ultramince pulvérisée sur un substrat et un générateur de plasma couplé par induction (15) produisant un plasma de gaz réactif et définissant une zone d'exposition au plasma (30) au niveau de laquelle ladite couche ultramince pulvérisée est exposée, caractérisé en ce qu'il existe une protection (20, 21), qui entoure ladite cible de façon latérale en étroite proximité dudit support de substrat rotatif (12) pour empêcher le gaz réactif de pénétrer dans ladite zone de formation de couche (13', 14'), et une autre protection (31), qui entoure de façon latérale le plasma de gaz réactif produit et qui s'étend en étroite proximité dudit support de substrat rotatif (12) pour empêcher le gaz de pulvérisation cathodique de pénétrer dans ladite zone d'exposition au plasma (30).

6. Appareillage selon la revendication 5, conçu pour effectuer en alternance une formation de couche pulvérisée et une exposition de la couche pulvérisée à un plasma de gaz réactif dans un cycle répété de fonctionnement.

7. Appareillage selon la revendication 5 ou 6, caractérisé en ce que deux dits moyens formant électrode de pulvérisation cathodique (13, 14) sont disposés de manière diamétralement opposée l'un par rapport à l'autre, de part et d'autre dudit support de substrat rotatif.
